# EUROPÄISCHE PATENTANMELDUNG

(11) **EP 2 264 901 A2**
(43) Veröffentlichungstag der Anmeldung: **22.12.2010**
(21) Anmeldenummer: 10005987.2
(22) Anmeldetag: 10.06.2010
(51) Int. Cl.: H03K 19/21

(54) **Integrierter Schaltkreis und Standartzelle eines integrierten Schaltkreises**

(30) Priorität: 18.06.2009 DE 102009029784
(71) Anmelder: Atmel Automotive GmbH, 74072 Heilbronn (DE)
(72) Erfinder: Ferchland, Tilo, Dr.-Ing., 01277 Dresden (DE); Vorwerk, Matthias, Dipl.-Ing., 01129 Dresden (DE); Riedel, Thorsten, Dipl.-Ing., 01217 Dresden (DE)
(74) Vertreter: Koch Müller Patentanwaltsgesellschaft mbH

(57) **Zusammenfassung**

Integrierter Schaltkreis und Standardzelle (100) eines integrierten Schaltkreises,
- mit einem Master-Slave-Flip-Flop (140),
- mit einer Vergleicher-Logik (190), an deren Eingängen das Eingangssignal (k) des Master-Slave-Flip-Flops (140), das invertierte Eingangssignal (nk) des Master-Slave-Flip-Flops (140), das Ausgangssignal (q) des Master-Slave-Flip-Flops (140) und das invertierte Ausgangssignal (nq) des Master-Slave-Flip-Flops (140) anliegen,
- bei der das Master-Slave-Flip-Flop (140) ein Master-Flip-Flop (150) und ein Slave-Flip-Flop (160) aufweist,
- bei der das Slave-Flip-Flop (160) ein erstes invertierendes Element (161) und ein zweites invertierendes Element (162) aufweist, wobei zur Rückkopplung ein Ausgang des ersten invertierenden Elements (161) mit einem Eingang des zweiten invertierenden Elements (162) und ein Ausgang des zweiten invertierenden Elements (162) mit einem Eingang des ersten invertierenden Elements (161) verbunden ist,
- bei der der Ausgang und der Eingang des zweiten invertierenden Elements (162) zur Ausgabe des Ausgangssignals (q) und des invertierten Ausgangssignals (nq) des Master-Slave-Flip-Flops (140) mit Eingängen der Vergleicher-Logik (190) verbindbar sind, so dass das zweite invertierende Element (162) und die Vergleicher-Logik (190) und ein Inverter (185) eine Exklusiv-Oder-Verknüpfung der Standardzelle (100) ausbilden.

## Beschreibung

Die vorliegende Erfindung betrifft einen integrierten Schaltkreis und eine Standardzelle eines integrierten Schaltkreises.

Aus U. Tietze, Ch. Schenk, "Halbleiterschaltungstechnik", 12. Auflage 2002, Seiten 675 bis 681 sind Schaltwerke zur Durchführung logischer Verknüpfungen mit der zusätzlichen Fähigkeit, einzelne Variablenzustände zu speichern, bekannt. Für integrierte Schaltkreise sind Flip-Flops vorgesehen, die sich in transparente Flip-Flops und Flip-Flops mit Zwischenspeicherung unterteilen. Zur Zwischenspeicherung kann ein Master-Slave-Flip-Flop mit einem Master-Flip-Flop (Meister) und einem Slave-Flip-Flop (Sklave) vorgesehen sein. Dieses kann als zweiflankengetriggertes Flip-Flop ausgebildet sein. Die Flip-Flops können beispielsweise mit Invertern, NAND-Gattem oder NOR-Gatter als rückgekoppelte invertierende Elemente realisiert werden.

Aus "CMOS - Circuit Design, Layout, and Simulation", R. J. Baker et al, IEEE PRESS 1998, Seite 270 ist ein flankengetriggertes D-Flip-Flop als Implementierung mit Transmission-Gates bekannt. Ein D-Flip-Flop kann beispielsweise eine Standardzelle sein, wie diese auf Seite 291 beschrieben ist. Standardzellen werden für einen Herstellungsprozess entworfen und bereits vor dem Anlauf der Massenfertigung mit geeigneten Teststrukturen gemessen und charakterisiert. Damit werden die kompletten Schaltungseigenschaften der Zelle über den geplanten Betriebsbereich (Spannung, Temperatur) erfasst und in entsprechende Simulationsmodelle umgesetzt. Eine Vielzahl von Zellen wird dabei in einer Zellbibliothek zusammengefasst.

Der Erfindung liegt die Aufgabe zu Grunde eine Standardzelle möglichst zu verbessern.

Diese Aufgabe wird durch eine Standardzelle mit den Merkmalen des unabhängigen Anspruchs 1 gelöst. Vorteilhafte Weiterbildungen sind Gegenstand von abhängigen Ansprüchen und in der Beschreibung enthalten.

Demzufolge ist eine Standardzelle eines monolithisch integrierten Schaltkreises vorgesehen.

Die Standardzelle weist einen Master-Slave-Flip-Flop auf. Vorzugsweise ist der Master-Slave-Flip-Flop ein Master-Slave-D-Flip-Flop.

Die Standardzelle weist eine Vergleicher-Logik auf. Die Vergleicher-Logik ist ausgebildet, Eingangssignal und Ausgangssignal des Master-Slave-Flip-Flops miteinander zu vergleichen. Vorzugsweise wird bei einem Unterschied zwischen Eingangssignal und Ausgangssignal ein korrespondierendes Vergleichssignal ausgegeben. Das Vergleichssignal kann beispielsweise zur Weiterleitung eines Taktsignals verwendet werden.

Die Standardzelle weist vorzugsweise eine Exklusiv-Oder-Funktion auf. Die Logik-Definition der Exklusiv-Oder-Funktion ist, dass nur dann ein High-Signal am Ausgang ausgegeben wird, wenn beide Eingänge für nicht-invertierte Signale (und somit auch beide Eingänge für invertierte Signale) unterschiedliches Eingangspotential aufweisen.

An Eingängen der Vergleicher-Logik liegt das nicht-invertierte Eingangssignal des Master-Slave-Flip-Flops, das invertierte Eingangssignal des Master-Slave-Flip-Flops, das nicht-invertierte Ausgangssignal des Master-Slave-Flip-Flops und das invertierte Ausgangssignal des Master-Slave-Flip-Flops an. Alle an den Eingängen der Vergleicher-Logik anliegenden Signale werden miteinander logisch verknüpft. Vorzugsweise bewirkt die logische Verknüpfung durch die Vergleicher-Logik einen Vergleich der Eingangs- und Ausgangssignale des Master-Slave-Flip-Flops.

Das Master-Slave-Flip-Flop weist ein Master-Flip-Flop und ein Slave-Flip-Flop auf. Das Slave-Flip-Flop weist ein erstes invertierendes Element und ein zweites invertierendes Element auf. Das erste invertierende Element und/oder das zweite invertierende Element sind beispielsweise ein NAND-Gatter, ein NOR-Gatter oder ein Inverter.

Zur Rückkopplung sind ein Ausgang des ersten invertierenden Elements mit einem Eingang des zweiten invertierenden Elements und ein Ausgang des zweiten invertierenden Elements mit einem Eingang des ersten invertierenden Elements verbunden. Vorzugsweise ist der Ausgang des zweiten invertierenden Elementes mit dem Eingang des ersten invertierenden Elements über ein Transmission-Gate zur Kopplung und Entkopplung verbunden.

Der Ausgang und der Eingang des zweiten invertierenden Elements sind zur Ausgabe des Ausgangssignals und des invertierten Ausgangssignals des Master-Slave-Flip-Flops mit Eingängen der Vergleicher-Logik verbindbar, so dass das zweite invertierende Element und die Vergleicher-Logik und ein weiterer Inverter zusammen eine Exklusiv-Oder-Verknüpfung der Standardzelle ausbilden.

Der Erfindung liegt weiterhin die Aufgabe zu Grunde einen möglichst verbesserten integrierten Schaltkreis anzugeben.

Diese Aufgabe wird durch den integrierten Schaltkreis mit den Merkmalen des unabhängigen Anspruchs 7 gelöst. Vorteilhafte Weiterbildungen sind Gegenstand von abhängigen Ansprüchen und in der Beschreibung enthalten.

Demzufolge ist ein integrierter Schaltkreis vorgesehen. Der integrierte Schaltkreis weist zumindest eine zuvor erläuterte Standardzelle, bevorzugt jedoch eine Vielzahl dieser Standardzellen auf. Bevorzugt sind die Standardzellen mit einer Taktverteilungsstruktur (engl. clock tree) verbunden.

Der integrierte Schaltkreis weist eine Takt-Torschaltung (engl. clock gate) und eine Taktschaltlogik auf.

Ein mit der Vergleicher-Logik verbundener Ausgang der Standardzelle ist zur Ausgabe eines Vergleichssignals bei unterschiedlichen Eingangs- und Ausgangssignalen des Master-Slave-Flip-Flops mit einem Eingang der Taktschaltlogik verbunden.

Der Ausgang der Taktschaltlogik ist mit einem Steuereingang der Takt-Torschaltung zum Schalten eines Takts auf einen Takteingang der Standardzelle anhand des Vergleichssignals verbunden.

Mittels dieser Funktionalität des Schaltens des Takts wird die Standardzelle nicht getaktet, wenn sich ihr Zustand ohnehin nicht ändern würde. Jeder angelegte Takt führt jedoch zu einem Verschiebungsstrom durch parasitäre Kapazitäten der Transistoren, so dass der Stromverbrauch durch das Abschalten des Takts reduziert werden kann.

Ein weiterer Aspekt der Erfindung ist eine Verwendung eines zuvor erläuterten integrierten Schaltkreises oder einer zuvor erläuterten Standardzelle für eine batteriebetriebene Schaltung. Die batteriebetriebene Schaltung ist vorzugsweise für ein Funknetz, vorzugsweise nach dem Industrie-Standard IEEE 802.15.4 oder einem anderen Industrie-Standard (WLAN, Bluetooth, WiMax) ausgebildet.

Die im Folgenden beschriebenen Weiterbildungen beziehen sich sowohl auf die Standardzelle, als auch auf den integrierten Schaltkreis als auch auf die Verwendung.

In einer vorteilhaften Weiterbildung ist vorgesehen, dass die Standardzelle einen Multiplexer aufweist, dessen Ausgang an einen Eingang des Master-Slave-Flip-Flops und vorzugsweise an einen Eingang der Vergleicher-Logik angeschlossen ist.

Gemäß einer bevorzugten Weiterbildungsvariante weist die Vergleicher-Logik einen Ausgang zur Ausgabe eines Vergleichssignals auf. Der Ausgang der Vergleicher-Logik ist mit einem Ausgang der Standardzelle verbunden. Der Multiplexer ermöglicht es für Betriebs- und Testzwecke mehrere Eingänge der Standardzelle auf den Eingang des Master-Slave-Flip-Flops zu schalten, wobei für alle Schaltstellungen ein Vergleichssignal mittels der Vergleicher-Logik ausgebbar ist.

In einer vorteilhaften Ausgestaltung der Erfindung weist die Standardzelle einen Ausgangstreiber auf, der mit dem Slave-Flip-Flop und einem Datenausgang der Standardzelle verbunden ist. Der Ausgangstreiber ist beispielsweise als Inverter ausgebildet.

Bevorzugt ist der integrierte Schaltkreis zur Durchführung einer Testfunktion ausgebildet. Vorzugsweise weist die Standardzelle hierzu einen Testeingang und einen Dateneingang auf. Die Standardzelle weist hierzu weiterhin einen mit dem Testeingang und dem Dateneingang verbundenen Multiplexer zur Umschaltung auf den Testeingang für die Testfunktion auf. Der Ausgang des Multiplexers ist mit einem Eingang des Master-Slave-Flip-Flops und einem Eingang der Vergleicher-Logik verbunden, vorzugsweise angeschlossen.

In einer bevorzugten Ausgestaltung bildet die Vergleicher-Logik eine erste ODER-Verknüpfung, eine zweite ODER-Verknüpfung und eine NAND-Verknüpfung ab. Die Eingänge der ersten ODER-Verknüpfung sind mit Eingängen der Vergleicher-Logik verbunden, vorzugsweise an die Eingänge angeschlossen. Die Eingänge der zweiten ODER-Verknüpfung sind mit Eingängen der Vergleicher-Logik verbunden, vorzugsweise an die Eingänge angeschlossen. Die Eingänge der NAND-Verknüpfung sind mit dem Ausgang der ersten ODER-Verknüpfung und mit dem Ausgang der zweiten ODER-Verknüpfung verbunden. Der Ausgang der NAND-Verknüpfung ist mit einem Ausgang der Vergleicher-Logik verbunden. Vorzugsweise ist der Ausgang der NAND-Verknüpfung an einen Ausgang der Standardzelle angeschlossen.

Die zuvor beschriebenen Weiterbildungsvarianten sind sowohl einzeln als auch in Kombination besonders vorteilhaft. Dabei können sämtliche Weiterbildungsvarianten untereinander kombiniert werden. Einige mögliche Kombinationen sind in der Beschreibung der Ausführungsbeispiele der Figuren erläutert. Diese dort dargestellten Möglichkeiten von Kombinationen der Weiterbildungsvarianten sind jedoch nicht abschließend.

Im Folgenden wird die Erfindung durch Ausführungsbeispiele anhand zeichnerischer Darstellungen näher erläutert.

Dabei zeigen
- Fig. 1: ein schematisches Blockschaltbild, und
- Fig. 2: einen Schaltplan einer Standardzelle.

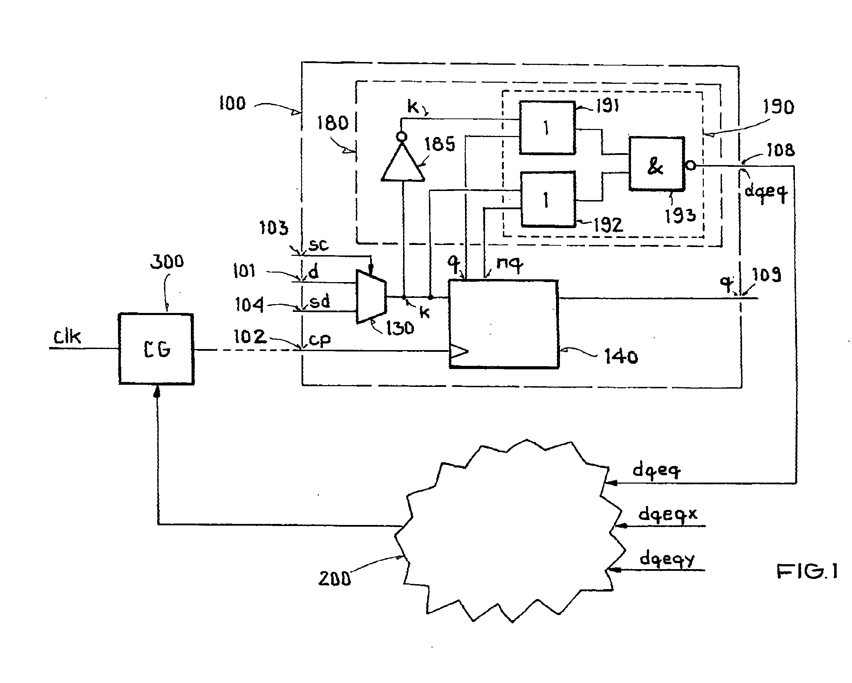

In Fig. 1 ist eine Standardzelle 100 eines integrierten Schaltkreises schematisch dargestellt. Die Standardzelle 100 weist ein Master-Slave-Flip-Flop 140 auf, dessen Ausgang mit einem Ausgang 109 der Standardzelle 100 zur Ausgabe des Datensignals q verbunden ist. Das Master-Slave-Flip-Flop 140 ist beispielsweise als D-Flip-Flop, JK-Flip-Flop oder RS-Flip-Flop ausgebildet. Im Folgenden wird die Schaltung der Fig. 1 beispielhaft mit einem Master-Slave-D-Flip-Flop 140 beschrieben. Der Takteingang des Master-Slave-D-Flip-Flops 140 ist mit einem Takteingang 102 der Standardzelle 100 verbunden. Der Dateneingang des Master-Slave-D-Flip-Flops 140 ist über einen Multiplexer 130 mit dem Dateneingang 101 der Standardzelle 100 für die Eingangsdaten d verbunden.

Zudem weist die Standardzelle 100 eine Auswertelogik 180 mit einer Vergleicher-Logik 190 auf. An den Eingängen der Vergleicher-Logik 190 liegen vier Signale an, das Eingangssignal k des Master-Slave-D-Flip-Flops 140, das invertierte Eingangssignal nk des Master-Slave-D-Flip-Flops 140, das Ausgangssignal q des Master-Slave-D-Flip-Flops 140 und das invertierte Ausgangssignal nq des Master-Slave-D-Flip-Flops 140. Im Ausführungsbeispiel der Fig. 1 wird das invertierte Eingangssignal nk des Master-Slave-D-Flip-Flops 140 durch den Inverter 185 gebildet.

Die Vergleicher-Logik 190 ist in ihrer logischen Funktion durch die zwei Oder-Gatter 191, 192 und das NAND-Gatter 193 schematisch dargestellt, wobei zur Implementierung keine Verwendung einzelner Gatter, sondern eine Transistorlogik eingesetzt wird. Die Vergleicher-Logik 190 bewirkt dabei eine erste VerODERung des (nicht-invertierten) Eingangssignals k und des invertierten Ausgangssignals nq des Master-Slave-D-Flip-Flops 140, eine zweite VerODERung des invertierten Eingangssignal nk und des (nicht-invertierten) Ausgangssignals q des Master-Slave-D-Flip-Flops 140 und eine VerUNDung der Ausgangssignale der VerODERungen, sowie gegebenenfalls eine Negation des Ausgangssignals der VerUNDung.

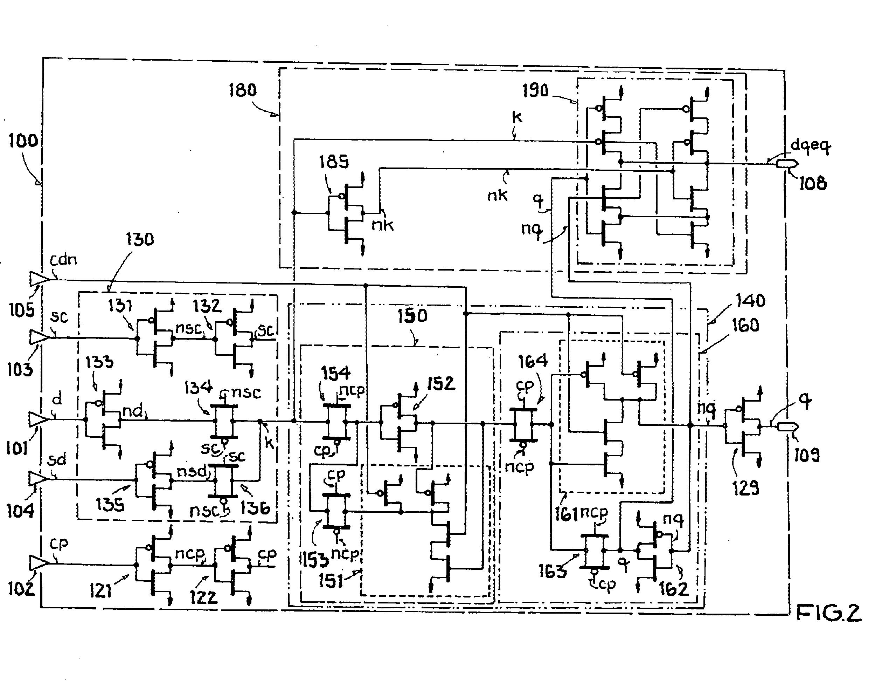

Am Ausgang 108 der Standardzelle 100 wird das durch die Vergleicher-Logik 190 gebildete Vergleichssignal dqeq ausgegeben. Vom Ausgang 108 gelangt das Vergleichssignal dqeq zu einer Logik 200, die mit einem Steuereingang einer Takt-Torschaltung 300 (engl. clock gate) verbunden ist. Die Logik 200 und die Takt-Torschaltung 300 sind eine besonders vereinfachte Darstellung eines Teils einer Takt-Baumstruktur (engl. clock tree) zur Steuerung der Taktweiterleitung an Register oder Flip-Flops, wie jenes der dargestellten Standardzelle 100. Die Takt-Torschaltung 300 schaltet im Falle eines Unterschieds zwischen dem Eingangssignal k und dem Ausgangssignal q einen Takt clk an den Takteingang 102 der Standardzelle 100 durch. Die Ansicht in Fig. 2 ist stark vereinfacht. An der Takt-Torschaltung 300 können (abweichend von Fig. 2) mehrere Flip-Flops angeschlossen sein (durch Strichlinierung angedeutet). Ebenfalls können eine Vielzahl von Vergleichssignalen dqeq, dqeqx, dqeqy mehrerer Standardzellen 100 durch die Logik 200 ausgewertet werden.

Die Schaltung in Fig. 1 ist zudem für Testfunktionen ausgebildet. Für die Testfunktionen ist der Eingang des Master-Slave-D-Flip-Flops 140 durch den Multiplexer 130 der Standardzelle 100 auf einen Testeingang 104 für das Testsignal sd umschaltbar. Die Umschaltung erfolgt mittels des Auswahlsignals sc am Auswahleingang 103. Durch die Integration der Auswerteschaltung 180 zusammen mit dem Master-Slave-D-Flip-Flop 140 und dem Multiplexer 130 in eine Standardzelle wird der profunde Effekt erzielt, dass ohne Zusatzaufwand auch in einem Testmodus die Vergleichsfunktion mittels der Vergleicher-Logik 190 verwendet werden kann und somit auch das so genannte Clock Gating mit getestet werden kann.

In Fig. 2 ist ein Ausführungsbeispiel einer Standardzelle 100 im Detail dargestellt. Die Standardzelle 100 der Fig. 2 soll für die folgenden Erläuterungen dabei die gleiche Funktionalität wie die Standardzelle 100 der Fig. 1 aufweisen. Durch Inverter 133, 135 am Eingang 101, 104 und einem Inverter 129 am Ausgang 109 sind die Signale in einem Master-Slave-D-Flip-Flop 140 gegenüber der Fig. 1 invertiert. Der Inverter 129 am Ausgang ist zum Treiben größerer Ströme ausgelegt. Die Eingangsinverter 133, 135 sind mit einer besonders kleinen Eingangskapazität ausgebildet.

Fig. 2 zeigt eine Implementierung einer Standardzelle 100 mit Invertern 121, 122, 129, 131, 132, 133, 135, 152, 162, 185, Transmission Gates 134, 136, 153, 154, 163, NAND-Gattern 151, 161 und der Vergleicher-Logik 190. Das Ausführungsbeispiel der Fig. 2 zeigt, wie sich die Vergleicher-Logik 190 durch acht Transistoren besonders einfach implementieren lässt.

Das Master-Slave-D-Flip-Flop 140 weist ein Master-Flip-Flop 150 und ein Slave-Flip-Flop 160 auf. Das Slave-Flip-Flop 160 weist das NAND-Gatter 161 als erstes invertierendes Element 161 und den Inverter 162 als zweites invertierendes Element 162 auf. Das erste invertierende Element 161 und das zweite invertierende Element 162 sind dabei rückgekoppelt. Zur Rückkopplung ist ein Ausgang des ersten invertierenden Elements 161 mit einem Eingang des zweiten invertierenden Elements 162 und ein Ausgang des zweiten invertierenden Elements 162 mit einem Eingang des ersten invertierenden Elements 161 verbunden. Anstelle des verwendeten Inverters 162 und NAND-Gatters 161 können - abweichend vom Ausführungsbeispiel der Fig. 2 - auch andere invertierende Elemente, wie beispielsweise NOR-Gatter verwendet werden. Auch das Master-Flip-Flop weist zwei rückgekoppelte invertierende Elemente 151, 152 als NAND-Gatter 151 respektive Inverter 152 auf.

Der Ausgang und der Eingang des zweiten invertierenden Elements 162 sind an Eingänge der Vergleicher-Logik 190 angeschlossen. Demzufolge muss das (nicht-invertierte) Ausgangssignals q und das invertierte Ausgangssignals nq nicht zusätzlich erzeugt werden, sondern wird innerhalb der Standardzelle 100 selbst durch das Master-Slave-D-Flip-Flop 140 bereitgestellt und an jeweils einen Eingang der Vergleicher-Logik 190 ausgegeben. Die Verdrahtung der Transistoren ist dabei besonders einfach und auf sehr kurzen Wegen innerhalb der Standardzelle 100 zu realisieren. Das zweite invertierende Element 162 und die Vergleicher-Logik 190 und ein Inverter 185 bilden eine Exklusiv-Oder-Verknüpfung der Standardzelle 100 aus. Die Exklusiv-Oder-Funktion ist also in die Standardzelle 100 selbst integriert, so dass kein zusätzliches Exklusiv-Oder-Gatter zusätzlich zur Standardzelle 100 benötigt wird. Dabei wir der technische Synergieeffekt ausgenutzt, dass das zweite invertierende Element 162 in Doppelfunktion als Bestandteil des Slave-D-Flip-Flops als auch als Inverter zur Erzeugung der Eingangssignale der Vergleicher-Logik 190 zur Ausbildung der Exklusiv-Oder-Verknüpfung dient.

Das Master-Slave-D-Flip-Flop 140 weist insgesamt vier Transmission-Gates 153, 154, 163, 164 auf, die durch das geschaltete Taktsignal cp und das invertierte geschaltete Taktsignal ncp angesteuert werden. Das geschaltete Taktsignal cp und das invertierte geschaltete Taktsignal ncp werden durch die beiden Inverter 121 und 122 bereitgestellt, wobei die Verbindungen zu den Transmission-Gates 153, 154, 163, 164 für eine bessere Übersichtlichkeit in Fig. 2 nicht dargestellt sind.

Der Multiplexer 130 weist ebenfalls Transmission-Gates 134, 136 als Schaltelemente auf. Die Transmission-Gates 134, 136 des Multiplexers 130 werden durch das Auswahlsignal sc und das invertierte Auswahlsignal nsc gesteuert, die durch die Inverter 131, 132 gebildet werden. Die Verbindungen zwischen den Transmission-Gates 134, 136 und den Invertern 131, 132 des Multiplexers 130 sind - für eine bessere Übersichtlichkeit - in Fig. 2 ebenfalls nicht dargestellt.

Der Eingang 105 der Standardzelle 100 ermöglicht das Rücksetzen des Master-Slave-D-Flip-Flops 140. Liegt das Rücksetzsignal cdn am Eingang 105 auf Low-Potential wird der Ausgang des NAND-Gatters 161 auf High, und damit der Ausgang der Standardzelle auf LOW zurückgesetzt. Ein High-Potential am Eingang 105 beeinflusst die Funktion des Master-Slave-D-Flip-Flops 140 hingegen nicht.

Die Auswerteschaltung 180 weist an seinem Eingang einen Inverter 185 auf, der das Eingangssignal k des Master-Slave-D-Flip-Flops 140 in ein invertiertes Eingangssignal nk invertiert. Alternativ kann das invertierte Eingangsignal nk auch durch einen Inverter des Multiplexers 130 oder durch einen Inverter des Master-Flip-Flops 150 in Doppelnutzung gebildet sein, was in Fig. 2 jedoch nicht dargestellt ist.

An der Vergleicher-Logik 190 liegen somit das Eingangssignal k des Master-Slave-D-Flip-Flops 140, das durch den Inverter 185 invertierte Eingangssignal nk des Master-Slave-D-Flip-Flops 140, das durch das Invertierende Elemente 162 gebildete nicht-invertierte Ausgangssignal q des Master-Slave-D-Flip-Flops 140 und das invertierte Ausgangssignal nq des Master-Slave-D-Flip-Flops 140 an. Hierzu ist die Vergleicher-Logik 190 durch zwei Anschlüsse unmittelbar mit dem Slave-Flip-Flop 160 verbunden.

Die erste ODER-Funktion der Vergleicher-Logik 190 wird durch die zwei NMOS-Transistoren mit paralleler Drain-Source-Strecke und die zweite ODER-Funktion wird durch zwei weitere NMOS-Transistoren mit paralleler Drain-Source-Strecke gebildet. Beide Paare sind für die NAND-Funktion in Reihe geschaltet. Die PMOS-Transistoren sind entsprechend logisch komplementär.

Durch die Standardzelle 100 kann gegenüber einer Implementierung mit einer Mehrzahl von Einzelzellen der Stromverbrauch deutlich reduziert werden. Zudem kann gegenüber Einzelzellen deutlich Fläche (10%-20%) eingespart werden und die Treiberstärke besser optimiert werden. Die Standardzelle 100 gemäß Fig. 2 realisiert eine Takt- oder Ereignis-basierte Speicherzelle (z.B. D-FF). Die Standardzelle 100 ist so entworfen, dass die Speicherzelle nur ein Änderungsereignis benötigt, wenn Ein- und Ausgangszustand nicht übereinstimmen. Der Vergleich über eine Bit-breite Speicherzelle wird durch die Vergleicher-Logik 190 an Stelle eines XOR-Gatters realisiert. Gegenüber einer reinen Flip-Flop-Standardzelle erhält die Standardzelle 100 gemäß Fig. 2 einen zusätzlichen Ausgang 108 der ein Vergleichsergebnis zwischen Eingangssignal k, nk und Ausgangssignal q, nq als Vergleichssignal dqeq ausgibt. Auch für einen Testmodus der Zelle (engl. Scan-flip-flop) kann die Vergleichsfunktion genutzt werden, so dass im Testmodus (engl. Scan Mode) der Vergleich zwischen Eingang und Ausgang genügt um den Takt für die Standardzelle 100 anzufordern.

Die Erfindung ist nicht auf die dargestellten Ausgestaltungsvarianten der Figuren 1 und 2 beschränkt. Beispielsweise ist es möglich einen anderen Typ von Master-Slave-Flip-Flop zu verwenden. Auch ist es möglich andere invertierende Elemente, wie NOR-Gatter zur verwenden. Die Funktionalität der Standardzelle 100 gemäß Fig. 2 kann besonders vorteilhaft für ein batteriebetriebenes Funksystem verwendet werden.

Bezugszeichenliste
- 100: Standardzelle
- 101: Dateneingang
- 102: Takteingang
- 103: Steuereingang
- 104: Testeingang
- 105: Setz-/Rücksetzeingang
- 108: Ausgang
- 109: Datenausgang
- 121, 122, 129, 131, 132,: Inverter
- 133, 135, 152, 162, 185:
- 130: Multiplexer, Schaltvorrichtung
- 134, 136, 153, 154, 163,: Transmission-Gate
- 164:
- 140: Master-Siave-D-Flip-Flop
- 150: Master-Flip-Flop
- 151, 161: NAND-Gatter
- 160: Slave-Flip-Flop
- 180: Auswertelogik
- 190: Vergleicher-Logik
- 191, 192: ODER-Logik
- 193: NAND-Logik
- 200: Logik
- 300, CG: Takt-Torschaltung

- clk: Takt
- cp: geschaltetes Taktsignal
- ncp: invertiertes geschaltetes Taktsignal
- d: Daten
- dqeq, dqeqx, dqeqy: Vergleichssignal
- k: Eingangsdaten
- nk: invertierte Eingangsdaten
- q: Ausgangsdaten
- nq: invertierte Ausgangsdaten
- sc: Steuersignal
- nsc: invertiertes Steuersignal
- sd: Testsignal
- nsd: invertiertes Testsignal

## Patentansprüche

1. Standardzelle (100) eines integrierten Schaltkreises,
- mit einem Master-Slave-Flip-Flop (140),
- mit einer Vergleicher-Logik (190), an deren Eingängen das Eingangssignal (k) des Master-Slave-Flip-Flops (140), das invertierte Eingangssignal (nk) des Master-Slave-Flip-Flops (140), das Ausgangssignal (q) des Master-Slave-Flip-Flops (140) und das invertierte Ausgangssignal (nq) des Master-Slave-Flip-Flops (140) anliegen,
- bei der das Master-Slave-Flip-Flop (140) ein Master-Flip-Flop (150) und ein Slave-Flip-Flop (160) aufweist,
- bei der das Slave-Flip-Flop (160) ein erstes invertierendes Element (161) und ein zweites invertierendes Element (162) aufweist, wobei zur Rückkopplung ein Ausgang des ersten invertierenden Elements (161) mit einem Eingang des zweiten invertierenden Elements (162) und ein Ausgang des zweiten invertierenden Elements (162) mit einem Eingang des ersten invertierenden Elements (161) verbindbar ist,
- bei der der Ausgang und der Eingang des zweiten invertierenden Elements (162) zur Ausgabe des Ausgangssignals (q) und des invertierten Ausgangssignals (nq) des Master-Slave-Flip-Flops (140) mit Eingängen der Vergleicher-Logik (190) verbunden sind, so dass das zweite invertierende Element (162) und die Vergleicher-Logik (190) und ein Inverter (185) eine Exklusiv-Oder-Verknüpfung der Standardzelle (100) ausbilden.

2. Standardzelle (100) nach Anspruch 1,
- mit einem Multiplexer (130), dessen Ausgang an einen Eingang des Master-Slave-Flip-Flops (140) angeschlossen ist.

3. Standardzelle (100) nach einem der Ansprüche 1 oder 2,
- mit einem Multiplexer (130), dessen Ausgang an einen Eingang der Vergleicher-Logik (190) angeschlossen ist.

4. Standardzelle (100) nach einem der vorhergehenden Ansprüche,
- bei dem die Vergleicher-Logik (190) einen Ausgang zur Ausgabe eines Vergleichssignals (dqeq) aufweist, der mit einem Ausgang (108) der Standardzelle (100) verbunden ist.

5. Standardzelle (100) nach einem der vorhergehenden Ansprüche,
- mit einem Ausgangstreiber (129), der mit dem Slave-Flip-Flop (160) und einem Datenausgang (109) der Standardzelle (100) verbunden ist.

6. Standardzelle (100) nach einem der vorhergehenden Ansprüche, bei der die Vergleicher-Logik (190)
- eine erste ODER-Verknüpfung (191), deren Eingänge mit Eingängen der Vergleicher-Logik (190) verbunden sind, und
- eine zweite ODER-Verknüpfung (192), deren Eingänge mit Eingängen der Vergleicher-Logik (190) verbunden sind, und
- eine NAND-Verknüpfung (193), deren Eingänge mit dem Ausgang der ersten ODER-Verknüpfung (191) und mit dem Ausgang der zweiten ODER-Verknüpfung (192) verbunden sind und deren Ausgang mit einem Ausgang der Vergleicher-Logik (190) verbunden ist, abbildet.

7. Integrierter Schaltkreis
- mit einer Standardzelle (100) nach einem der vorhergehenden Ansprüche,
- mit einer Takt-Torschaltung (300) (clock gate) und
- mit einer Taktschaltlogik (200),
- bei dem ein mit der Vergleicher-Logik (190) verbundener Ausgang (108) der Standardzelle (100) zur Ausgabe eines Vergleichssignals (dqeq) bei unterschiedlichen Eingangs- (k, nk) und Ausgangssignalen (q, nq) des Master-Slave-Flip-Flops (140) mit einem Eingang der Taktschaltlogik (200) verbunden ist,
- bei dem der Ausgang der Taktschaltlogik (200) mit einem Steuereingang der Takt-Torschaltung (300) zum Schalten eines Takts (clk) auf einen Takteingang (102) der Standardzelle (100) anhand des Vergleichssignals (dqeq) verbunden ist.

8. Integrierter Schaltkreis nach Anspruch 7,
der zur Durchführung einer Testfunktion ausgebildet ist,
- bei dem die Standardzelle (100) einen Testeingang (104) und einen Dateneingang (101) aufweist,
- bei dem die Standardzelle (100) einen mit dem Testeingang (104) und dem Dateneingang (101) verbundenen Multiplexer (130) zur Umschaltung auf den Testeingang (104) für die Testfunktion aufweist, dessen Ausgang mit einem Eingang Master-Slave-Flip-Flops (140) und einem Eingang der Vergleicher-Logik (190) verbunden ist.

9. Verwendung eines integrierten Schaltkreises nach Anspruch 7 oder einer Standardzelle nach einem der vorhergehenden Ansprüche für eine batteriebetriebene Schaltung, insbesondere eines Funknetzes, insbesondere nach dem Industrie-Standard IEEE 802.15.4.
